# EUROPEAN PATENT SPECIFICATION

(11) **EP 3 152 183 B1**
(45) Date of publication and mention of the grant of the patent: **15.04.2020**
(21) Application number: 14730115.4
(22) Date of filing: 04.06.2014
(51) Int. Cl.: C04B 35/495, C04B 35/622, C04B 35/624, C23C 14/08, H01M 4/36, H01M 10/052, H01M 4/131, H01M 4/485, H01M 10/0562, C01G 35/00

(54) **LITHIUM-ION CONDUCTIVE CERAMICS**
LEITENDE LITHIUM-IONEN-KERAMIK
CÉRAMIQUE CONDUCTRICE LITHIUM-ION

(43) Date of publication of application: 12.04.2017
(73) Proprietor: Toyota Motor Europe NV/SA, 1140 Brussel (BE)
(72) Inventor: YADA, Chihiro, B-1150 Brussels (BE); LEE, Christopher E., Southampton Hampshire SO16 7NS (GB); LAUGHMAN, David, Southampton Hampshire SO16 7NS (GB); HANNAH, Louise, Southampton Hampshire SO16 7NS (GB); HAYDEN, Brian E., Southampton Hampshire SO16 7NS (GB)
(74) Representative: Cabinet Beau de Loménie
(86) International application number: PCT/EP2014/061603
(87) International publication number: WO 2015/185129

(56) References cited:
- US-A- 4 001 076
- US-B2- 7 993 782
- K. Y. BAK ET AL: "Structural and electrical properties of Nb-substituted LiTa1-xNbxO3", SAINS MALAYSIANA, vol. 43, no. 10, 1 February 2014 (2014-02-01), pages 1573-1582, XP055163878,
- KULINICH S A ET AL: "Thermal plasma fabricated lithium niobate-tantalate films on sapphire substrate", JOURNAL OF VACUUM SCIENCE AND TECHNOLOGY: PART A, AVS /AIP, MELVILLE, NY., US, vol. 21, no. 4, 1 July 2003 (2003-07-01), pages 994-1003, XP012006502, ISSN: 0734-2101, DOI: 10.1116/1.1582451
- KULINICH S A ET AL: "Lithium niobate-tantalate thin films on Si by thermal plasma spray CVD", THIN SOLID FILMS, ELSEVIER-SEQUOIA S.A. LAUSANNE, CH, vol. 407, no. 1-2, 22 March 2002 (2002-03-22), pages 60-66, XP004352897, ISSN: 0040-6090, DOI: 10.1016/S0040-6090(02)00013-5
- KULINICH S A ET AL: "Effect of the substrate temperature and deposition rate on the initial growth of thin lithium niobate-tantalate films deposited from a thermal plasma", PHYSICS OF THE SOLID STATE, NAUKA/INTERPERIODICA, MO, vol. 48, no. 5, 16 May 2006 (2006-05-16), pages 904-911, XP019412540, ISSN: 1090-6460, DOI: 10.1134/S1063783406050155
- CHIA-LIANG KUO ET AL: "Thermal behavior of the nonstoichiometric lithium niobate powders synthesized via a combustion method", CERAMICS INTERNATIONAL, ELSEVIER, AMSTERDAM, NL, vol. 38, no. 5, 7 January 2012 (2012-01-07), pages 3729-3733, XP028409705, ISSN: 0272-8842, DOI: 10.1016/J.CERAMINT.2012.01.017 [retrieved on 2012-01-15]
- MASANOBU NAKAYAMA ET AL: "Ionic conduction of lithium in B-site substituted perovskite compounds, (Li0.1La0.3)yMxNb1 - xO3 (M = Zr, Ti, Ta)", JOURNAL OF MATERIALS CHEMISTRY, vol. 12, no. 5, 17 April 2002 (2002-04-17) , pages 1500-1504, XP055164418, ISSN: 0959-9428, DOI: 10.1039/b200310d

## Description

### Field of the invention

The present invention relates to mixed oxides of lithium, niobium and tantalum, as well as to a process for making the mixed oxides, and also to all-solid-state lithium batteries comprising the mixed oxides. The invention describes the use of the mixed oxides as buffer layers between a positive electrode active material and a solid electrolyte, in a battery, and the use of the mixed oxides as solid electrolyte materials.

### Background art

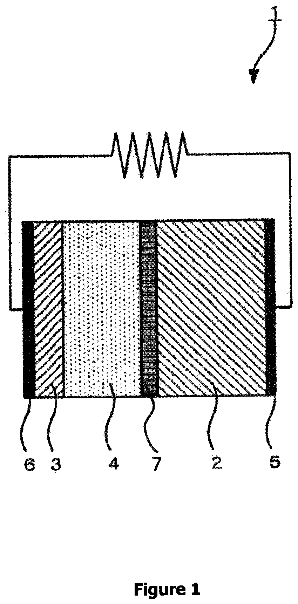

The basic structure of an exemplary all-solid-state battery (1) is illustrated in Figure 1. In a typical example, it may mainly comprise the following parts:
- Cathode (2)
- Buffer layer (7)
- Solid electrolyte (4)
- Anode (3).

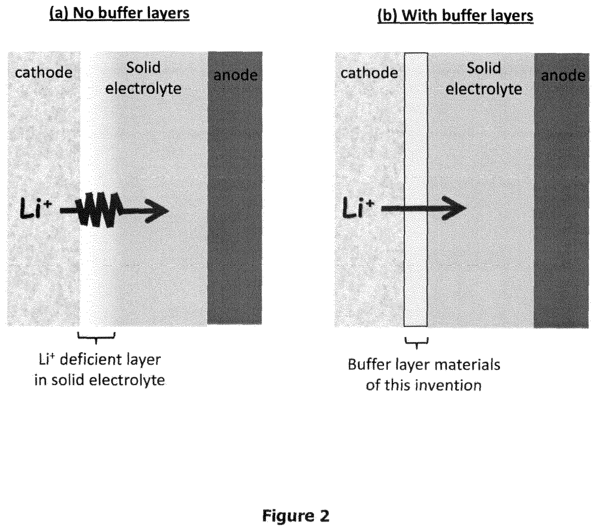

Also shown in Figure 1 are the cathode current collector (5) and the anode current collector (6). In such an arrangement, a buffer layer (7) is interposed at cathode/solid electrolyte interface in order to enhance lithium-ion transfer at the interface, resulting in high-power batteries. In the absence of a buffer layer, there may be a lithium ion deficient layer at the interface between the cathode and the solid electrolyte layer, as illustrated in Figure 2.

In references [1] C. Yada, A. Ohmori, K. Ide, H. Yamasaki, T. Kato, T. Saito, F. Sagane, Y. Iriyama, Adv. Energy Mat., 2014, 1301416, and [1'] C. Yada, A. Ohmori, Y. Iriyama, Japanese Patent JP-2013-062133, the authors studied the effect of dielectric materials (i.e. high permittivity materials) interposed at cathode/solid electrolyte interfaces in all-solid-state batteries. In their example, they used BaTiO₃ nano-particles as the buffer materials, and resolved Li⁺ deficient layers at the interfaces. However, in this approach, the effect was not sufficient because BaTiO₃ nano-particles act as insulators through which Li⁺ cannot pass.

In references [2] N. Ohta, K. Takada, I. Sakaguchi, L. Zhang, R. Ma, K. Fukuda, M. Osada, T. Sasaki, Electrochem. Commun., 9 (2007) 1486-1490, and [2'] K. Takada, N. Ohta, L. Zhang, T. Sasaki, US Patent, US 7 993 782 B2, the authors tested the effect of amorphous LiNbO₃ or LiTaO₃ as a buffer layer at cathode/solid electrolyte interfaces in all-solid-state batteries. They stated that high-resistance layers are developed at cathode/solid electrolyte interfaces because of the large chemical potential difference of lithium-ions. Such high-resistance layers can be resolved by the amorphous LiNbO₃ and LiTaO₃ buffer layers.

US 7 993 782 discloses an all-solid lithium battery comprising a negative electrode, a lithium ion-conducting solid electrolyte as an electrolyte, and a positive electrode, wherein the lithium ion-conducting solid electrolyte is mainly composed of a sulfide, and the surface of a positive electrode active material is coated with a lithium ion-conducting oxide. The lithium ion-conducting oxide may contain lithium and one or both of niobium and tantalum.

In reference [3] A. M. Glass, K. Nassau, T. J. Negran, Journal of Applied Physics, 49 (1978) 4808, the authors synthesized Li-Nb-O and Li-Ta-O glass by a twin-roller quenching method, and measured their ionic conductivities. The ionic conductivity of LiₓNb₁₋ₓO₃ glass (0.46 < x < 0.56) was found to range from 1 x 10⁻⁷ S/cm to 3.5 x 10⁻⁶ S/cm, while that of the LiTaO₃ glass was about 5 x 10⁻⁶ S/cm.

In reference [4] K. Yamamoto, T Taniuchi, US 4 951 293, the authors disclosed a laser source with optical nonlinear device with a substrate of LiNb_{xT}a₁₋ₓO₃ crystal where x denotes a value between 0 and 1.

In addition, Bak et al., Sains Malaysiana, 43(10) (2014), 1573-1582 describe ternary oxides, specifically LiTa_{0.75}Nb_{0.25}O₃, LiTa_{0.5}Nb_{0.5}O₃, and LiTa_{0.25}Nb_{0.75}O₃. Kulinich et al., J. Vac. Sci. Technol. A 21(4) (2003), 994-1003, Kulinich et al., Thin Solid Films, 407 (2002), 60-66, and Kulinich et al., Physics of the Solid State, 2006 (48:5), 904-911, describe films of formula LiNb₁₋ₓTaₓO₃ where 0 ≤ x ≤ 1.

### Summary of the invention

The present inventors have sought to develop new compositions for buffer layers to be used at the cathode / solid electrolyte interface, in particular in all-solid-state batteries, wherein the buffer layers would provide effective lithium ion conduction and avoid the problem of Li⁺-deficient layers, and also the inventors have sought to identify new materials suitable as solid electrolyte materials.

It has surprisingly been discovered that appropriate materials for these purposes can be found among ternary Li-Nb-Ta oxides, such materials providing favourable ranges of both ionic conductivity and permittivity enabling improved buffer layers to be prepared, as well as improved solid electrolyte materials. In the present invention, ternary Li-Nb-Ta oxides are proposed having from 53 to 56 atom % of Li, from 15 to 30 atom % of Nb, and from 17 to 29 atom % of Ta.

The invention therefore relates to a ternary mixed oxide of lithium, niobium and tantalum of formula (I):

LiₓNb_{y}Ta_{z}Oₐ (I)

wherein:
- 0.53 ≤ x ≤ 0.56
- 0.15 ≤ y ≤ 0.30, and
- 0.17 ≤ z ≤ 0.29,
wherein x + y + z = 1.00, and
a is ≤ 3.00.

In preferred embodiment of the present invention, in the mixed oxide of lithium, niobium and tantalum, said mixed oxide shows:
- an ionic conductivity of at least 2.0 x 10⁻⁶ S/cm, and
- a permittivity of at least 100.

More preferably, the said mixed oxide shows an ionic conductivity of at least 3.5 x 10⁻⁶ S/cm, and/or a permittivity of at least 150.

In a preferred embodiment of the present invention, in the mixed oxide of lithium, niobium and tantalum, said mixed oxide is partially amorphous.

The above listed embodiments of the present invention may be combined.

The present invention also relates to a process for preparing a mixed oxide of lithium, niobium and tantalum according to the present invention, wherein the process comprises the following steps:
- a thin film of Li, Nb and Ta oxide is prepared;
- an annealing process is carried out at a temperature of at least 300°C.

The present invention also relates to the use of the mixed oxide of lithium, niobium and tantalum according to the invention as a buffer layer between a positive electrode active material and a solid electrolyte, in a battery, or, in an alternative embodiment, as a solid electrolyte material in a battery. The present invention also relates to all-solid-state lithium batteries wherein the mixed oxides of the invention are used in either of these two roles.

### Brief description of the drawings

Figure 1 is a schematic view describing the structure of an all-solid-state lithium battery.
Figure 2 is a schematic view illustrating the influence of a buffer layer in alleviating the problem of formation of a Li⁺-deficient layer.
Figure 3 is a schematic view illustrating the experimental setup of HT-PVD (left) and a concentration gradient Li-Nb-Ta-O thin film.
Figure 4 illustrates a typical configuration of electrical measurements for annealed films.
Figure 5 shows conductivity data measured for Li-Nb-Ta-O thin films after heating to 450°C in argon gas plotted in (a) with a Li-rich (55 at.%) tie-line. In (b) the raw data along the tie-line in as open circles and filled the circle show the mean values. In (c) a line of constant Nb/Ta ratio is shown. In (d) the raw data along the line of constant Nb/Ta ratio is shown as open circles and filled circles show the mean values.
Figure 6 shows the compositional range of mixed oxides according to the invention exhibiting ionic conductivity larger than 3.5 x 10⁻⁶ S/cm and permittivity larger than 150. (The samples were annealed at 400°C.)
Figure 7 shows the compositional range of mixed oxides according to the invention exhibiting ionic conductivity σ > 3.5 x 10⁻⁶ S/cm and permittivity 100 < ε < 150 (●), or ionic conductivity 2 x 10⁻⁶ S/cm < σ < 3.5 x 10⁻⁶ S/cm and permittivity ε > 150 (○). (The samples were annealed at 400°C.)
Figure 8 shows the compositional range of mixed oxides according to the invention exhibiting ionic conductivity between 2 x 10⁻⁶ S/cm < σ < 3.5 x 10⁻⁶ S/cm and permittivity between 100 < ε < 150. (The samples were annealed at 400°C.)
Figure 9 shows the compositional range of mixed oxides according to the invention exhibiting ionic conductivity larger than 3.5 x 10⁻⁶ S/cm and permittivity larger than 150. (The samples were annealed at 450°C.)
Figure 10 shows the compositional range of mixed oxides according to the invention exhibiting ionic conductivity between 2 x 10⁻⁶ S/cm < σ < 3.5 x 10⁻⁶ S/cm and permittivity between 100 < ε < 150. (The samples were annealed at 450°C.)
Figure 11 shows the dependence of ionic conductivities on annealing temperature for materials of the present invention.
Figure 12 shows the dependence of permittivity on annealing temperature for materials of the present invention.
Figure 13 shows XRD patterns of a sample with composition (Li at%, Ta at%, Nb at%) = (54.4, 23.0, 22.5).
Figure 14 shows Raman spectra of a sample with composition of (Li at%, Ta at%, Nb at%) = (54.4, 23.0, 22.5).
Figure 15a shows TEM images and electron diffraction patterns of a sample with composition of (Li at%, Ta at%, Nb at%) = (54.4, 23.0, 22.5) annealed at 450°C. Figure 15b illustrates the structures being investigated and the types of images observed in a schematic manner.
Figure 16a shows TEM images and electron diffraction patterns of a sample with composition of (Li at%, Ta at%, Nb at%) = (49.9, 24.2, 25.9) annealed at 550°C. Figure 16b illustrates the structures being investigated and the types of images observed in a schematic manner.
Figure 17a shows TEM images and electron diffraction patterns of a sample with composition of (Li at%, Ta at%, Nb at%) = (54.9, 19.5, 25.6) annealed at 450°C. Figure 17b illustrates the structures being investigated and the types of images observed in a schematic manner.
Figure 18a shows a preferred embodiment in which ternary Li-Nb-Ta oxides of the invention are used as barrier materials between the cathode and the solid electrolyte, and Figure 18b shows a distinct preferred embodiment in which ternary Li-Nb-Ta oxides of the invention are used themselves as components in the solid electrolyte layer.
Figure 19 shows a charge-discharge curve measured at a rate of ca. C/2 for a battery prepared using a barrier layer according to the present invention.

### Detailed description of the invention

In order to prepare Li-Nb-Ta oxide materials according to the present invention, an appropriate production method includes a first preparation of a thin film, using methods such as a sol-gel process, physical vapour deposition or chemical vapour deposition.

In a typical sol-gel process, the Li-Nb-Ta oxide layer can be formed from an ethanol solution containing alkoxides of Li, Nb, and Ta. At first, Li metal is dissolved in anhydrous ethanol under an Ar atmosphere, and then is mixed with niobium pentaethoxide and tantalum pentaethoxide. The solution is sprayed onto a substrate, and then annealed at an appropriate temperature.

Among possible typical physical vapour deposition processes, one example is r.f. magnetron sputtering, where a target of Li-Nb-Ta-O pellet is sputtered by an appropriate atmosphere (e.g. Ar or O₂) inside a vacuum chamber, and then the product thin film is deposited on a substrate (e.g. Au, Si/SiO₂/TiO_{2/}Pt). Another example is the procedure described below in the experimental section of the present application.

In the first step of the process for preparing a mixed oxide of lithium, niobium and tantalum according to the present invention, a thin film of Li-Nb-Ta oxide is generated, whose thickness is preferably at least 5 nm and at most 1000 nm, more preferably at least 10 nm and at most 500 nm.

In a next step, an annealing process is carried out, at a temperature of at least 300°C.

Concerning appropriate experimental or industrial setups for annealing processes, one example is using a muffle oven, where the sample can be annealed at desired temperatures. A tube furnace or a rapid thermal annealer can be also used, in which case the atmosphere can be easily controlled.

In the present invention, it is preferred to conduct the annealing process under an atmosphere not containing oxygen, such as an inert atmosphere, which in a favourable embodiment may be an argon atmosphere. Annealing in oxygen appears to have a detrimental effect on the ionic conductivity of the final products, for as yet unclear reasons, at least for final products prepared based on a thin film laid down according to the method used in the experimental work set forth in the present application. However, other atmospheres (e.g. air, O₂) might be the best conditions in the case of other processing techniques (e.g. sol-gel, chemical vapour deposition).

In the present invention, it has been observed that ionic conductivity and permittivity are clearly affected by annealing temperature. It also appears that when the annealed ternary Li-Nb-Ta oxide product is amorphous, containing some crystalline regions, but not being fully crystalline, this is valuable in providing simultaneously high conductivity and permittivity. Although generally most favourable composition ranges have been identified through the experimental work of the present inventors, in fact that the exact boundary at which a given numerical threshold of conductivity and/or permittivity is surpassed is affected by the annealing conditions as well as the compositional range.

Based on the experimental study presented herein, the present inventors assigned tested Li-Nb-Ta oxides into three areas of performance, Area 1 being the highest zone of performance, followed by Area 2 and then Area 3.

**Area 1:** The compositions of "Area 1" show ionic conductivity larger than 3.5 x 10⁻⁶ S/cm, and permittivity larger than 150 at the same time. When these materials are used as buffer layers at cathode/solid electrolyte interfaces in all-solid-state batteries, it is expected that the power density of batteries will increase most effectively.

**Area 2:** The compositions of "Area 2" are effective after those of "Area 1". The compositions of "Area 2" have either of the following properties.
- Ionic conductivity larger than 3.5 x 10⁻⁶ S/cm as well as permittivity between 100 and 150, or
- Ionic conductivity between 2.0 x 10⁻⁶ S/cm and 3.5 x 10⁻⁶ S/cm as well as permittivity larger than 150.

**Area 3:** The compositions of "Area 3" are effective after those of "Area 2". The compositions of "Area 3" have both ionic conductivity between 2 x 10⁻⁶ S/cm and 3.5 x 10⁻⁶ S/cm as well as permittivity of between 100 and 150.

Although the exact compositional ranges are also affected by the annealing temperature, it is generally observed that the most favourable conductivity and permittivity properties (Area 1 properties) are observed for ternary oxides having the formula:

LiₓNb_{y}Ta_{z}Oₐ (I)

wherein:
- 0.53 ≤ x ≤ 0.56
- 0.15 ≤ y ≤ 0.30, and
- 0.17 ≤ z ≤ 0.29,
wherein x + y + z = 1.00, and
a is ≤ 3.00.

Thus, in the present invention, as regards the metallic (not the oxygen) components, there is between 53 and 56 atom% Li, between 15 and 30 atom% Nb, and between 17 and 29 atom% Ta.

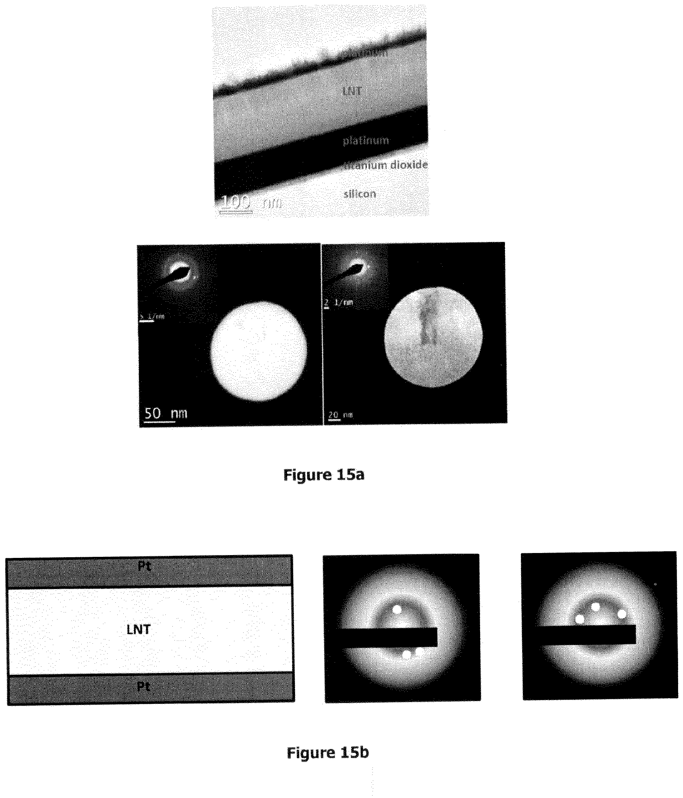

Without wishing to be bound by any particular theory, it is postulated by the inventors that for ternary oxide materials (here Li-Nb-Ta oxides) to act successfully as a barrier layer between a cathode layer and an electrolyte layer, it is preferable for there to be in the barrier layer material both amorphous zones, which may show higher Li⁺ ion conductivity, as well as crystalline dielectric zones which reduce the steepness of the voltage drop. In the annealing process, which does not melt the oxide materials, a temperature zone is reached which is between the glass transition temperature and the crystallisation temperature, such as to induce at least some reorganisation on a microscopic level. As shown in Figures 15 to 17, electron diffraction patterns show some clear dots implying partial, but not complete, crystallinity.

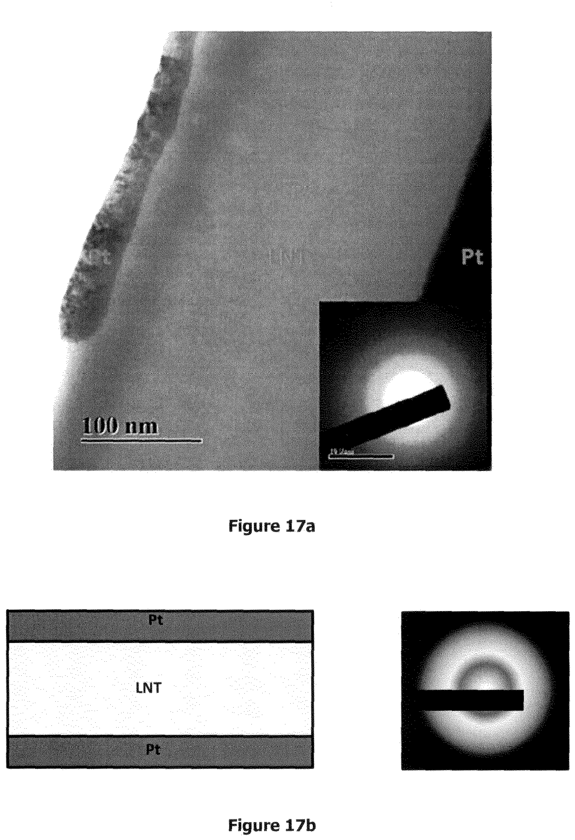

Hence in one aspect, the present invention relates to a mixed oxide of lithium, niobium and tantalum, wherein said mixed oxide is partially amorphous. A partially amorphous mixed oxide of lithium, niobium and tantalum, which has some crystalline zones but is not fully crystalline, appears to be appropriate for use in the present invention. It may also be noted from Fig. 17 that a 100% amorphous sample also seems to have an effect.

In one aspect of the present invention, it is intended to use a mixed oxide of lithium, niobium and tantalum as defined herein as a buffer layer between a positive electrode active material and a solid electrolyte, in a battery.

In one aspect, the present invention thus relates to an all-solid-state lithium battery comprising the following elements:
- a positive electrode active material layer;
- a buffer layer;
- a solid electrolyte;
- a negative electrode active material layer,
wherein the buffer layer, acting as an interface between the positive electrode active material and the solid electrolyte, contains a mixed oxide of lithium, niobium and tantalum as defined herein.

In such an all-solid-state lithium battery according to the present invention, the buffer layer will appropriately have a thickness of at least 1 nanometre and at most 1 micrometre.

In an all-solid-state lithium battery according to present invention, the buffer layer may comprise particles of the said mixed oxide of lithium, niobium and tantalum, with a mean particle size of at most 0.5 micrometres.

In another aspect of the present invention, a mixed oxide of lithium, niobium and tantalum as defined herein may be used as a component making up part or all of the solid electrolyte itself. In effect, the mixed oxides of the present invention show higher conductivity than typical solid electrolytes such as LiPON and LiNbO₃. In one preferred embodiment of this aspect of the present invention, the solid electrolyte comprises particles of the said mixed oxide of lithium, niobium and tantalum, with a mean particle size of at most 10 micrometres.

Concerning the positive active material (cathode active material) used for the present invention, which can be used in the positive electrode (cathode) active material layer, this is not especially limited if the average operating potential becomes more than 4 V (vs. Li/Li⁺). As an average operating potential of positive active material, this is appropriately more than 4 V (vs. Li/Li⁺), and it is preferable that it is within the limits of 4.0 V - 6.0 V, still more preferably within the limits of 4.5 V - 5.5 V. The average operating potential in the present invention can be evaluated using cyclic voltammetry, for example. In particular, when cyclic voltammetry is measured at a small electric potential speed like 0.1 mV/sec, it can be considered that the average value of the voltage which gives the peak current on the side of oxidation, and the voltage which gives the peak current on the side of reduction is the average operating potential.

As a positive active material, especially if the average operating potential is made with more than 4 V (vs. Li/Li⁺), there is no specific limitation, but it is preferable that the material is an oxide positive active material, which can have a high energy density.

A compound which has the spinel type structure denoted by general formula LiM₂O₄ (M is at least one kind of transition metal element), as an example of positive active material, can be mentioned as an example. As regards M of the above-mentioned general formula LiM₂O₄, especially if it is a transition metal element, it will not be limited, but it is preferable that it is at least one kind chosen from the group which consists of Ni, Mn, Cr, Co, V, and Ti, for example, and it is more preferable that it is at least one kind chosen from the group which consists of Ni, Mn, and Cr especially. Specifically, LiCr_{0.05}Ni_{0.50}Mn_{1.45}O₄, LiCrMnO₄, LiNi_{0.5}Mn_{1.5}O₄, etc. can be mentioned. The compound which has the Olivine type structure denoted by general formula LiMPO₄ (M is at least one kind of transition metal element) as other examples of positive active material can be mentioned. M in the above-mentioned general formula will not be limited especially if it is a transition metal element, but it is preferable that it is at least one kind chosen from Mn, Co, Ni, and the group that consists of V, for example, and it is more preferable that it is at least one kind chosen from the group which consists of Mn, Co, and Ni especially. Specifically, LiMnPO₄, LiCoPO₄, LiNiPO₄, etc. can be mentioned. The compound which has the layer structure denoted by general formula LiMO₂ (M is at least 1 type of a transition metal element) as other examples of positive active material can be mentioned. Specifically, LiNi_{0.5}Mn_{0.5}O₂ and LiNi_{0.33}Co_{0.33}Mn_{0.33}O₂ etc. can be mentioned. As examples other than the positive active material mentioned above, a Li₂MnO₃-LiNi_{1/3}Co_{1/3}Mn_{1/3}O₂ solid solution, a Li₂MnO₃-LiNi_{0.5}Mn_{1.5}O₂ solid solution, a Li₂MnO₃-LiFeO₂ solid solution, etc. can be mentioned.

As regards the form of the positive active material, a particle shape, such as the shape of a true ball and the shape of an elliptical ball, thin film form, etc. can be mentioned, as an example. As for the mean particle diameter, when the positive active material has a particle shape, it is preferable that it is within the size range of 0.1 micrometer - 50 micrometers, for example. As for the content of the positive active material in a positive active material layer, it is preferable that it is in the range of 10 % by weight to 99% by weight, for example, more preferably from 20 % by weight to 90% by weight.

Concerning the positive active material layer, in addition to the positive active material mentioned above, if needed, the positive active material layer in the present invention may contain other materials, for example, solid electrolyte materials etc. As for the content of the solid electrolyte materials in a positive active material layer, it is preferable that this content is 1 % by weight to 90% by weight, more preferably 10 % by weight to 80% by weight.

Furthermore, a positive active material layer may contain an electrically conductive agent from a viewpoint of improving the conductivity of a positive active material layer, other than the solid electrolyte materials mentioned above. As electrically conductive material, acetylene black, Ketjenblack, a carbon fiber, etc. can be mentioned, for example. A positive active material may also contain a binding agent. As such a binding material (binding agent), fluorine-based binding materials, such as polyvinylidene fluoride (PVDF) and polytetrafluoroethylene (PTFE), etc. can be mentioned, for example.

Although the thickness of a positive active material layer may change according to the kind of all-solid-state battery made, it is generally preferable that it is within the range of 0.1 micrometer - 1000 micrometers.

Concerning the solid electrolyte layer in the present invention, the latter is formed between a positive active material layer and a negative electrode active material layer (and/or between a buffer layer, which coats the positive active material layer, and the negative electrode active material layer), and contains solid electrolyte materials. As for the relative dielectric constant of the solid electrolyte materials used for the present invention, it is preferable that this value is lower than the relative dielectric constant of buffer layer material of the invention. As such solid electrolyte materials, sulfide solid electrolyte materials, oxide solid electrolyte materials, etc. can be mentioned, for example.

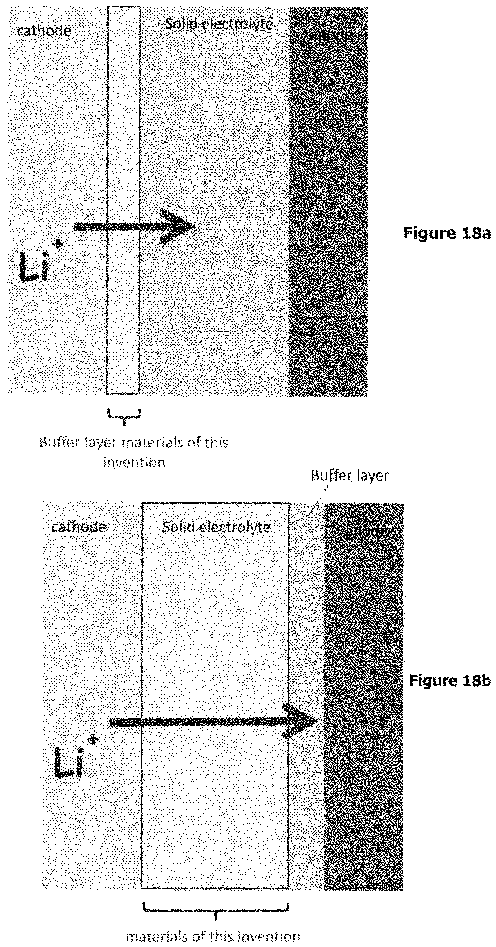

As oxide solid electrolyte materials used for the present invention, LiPON (for example, Li_{2.9}PO_{3.3}N_{0.46}), LiLaTiO (for example, Li_{0.34}La_{0.51}TiO₃), LiLaZrO (for example, Li₇La₃Zr₂O₁₂), etc. can be mentioned. Especially, since membranes can be formed at a room temperature, especially LiPON is preferable. As other examples of oxide solid electrolyte materials, compounds which have NASICON mold structure can also be mentioned. As an example of a compound which has NASICON mold structure, the compound denoted by general formula Li₁₊ₓAlₓGe₂₋ₓ(PO₄)₃ (0<=x<=2) can be mentioned. In the above-mentioned general formula, as for the range of x, it is preferable that it is 0.3 or more, and preferably 1.7 or less, more preferably 1.0 or less. Especially, in the present invention, it is preferable that the above-mentioned oxide solid electrolyte materials are Li_{1.5}Al_{0.5}Ge_{1.5}(PO₄)₃. As other examples of the compound which has NASICON mold structure, the compound denoted by general formula Li₁₊ₓAlₓTi₂₋ₓ(PO₄)₃ (0<=x<=2) can be mentioned. In the above-mentioned general formula, as for the range of x, it is preferably 0.3 or more, and preferably 1.7 or less, more preferably 1.0 or less. Particularly preferable solid electrolyte materials in the oxide group are Li_{1.3}Al_{0.3}Ti_{1.7}(PO₄)₃. Another possibility is a lithium borosilicate. Further, as mentioned above (and illustrated in Figures 18a and 18b), although the ternary Li-Nb-Ta oxides of the present invention may appropriately be used in barrier materials, between the cathode and the solid electrolyte layer, they may also themselves be components forming part or all of the electrolyte layer.

As sulfide solid electrolyte materials used for the present invention, possibilities include, for example, Li₁₀GeP₂S₁₂, Li₂S-P₂S₅ and Li₂S-P₂S₅-LiI, Li₂S-P₂S₅-Li₂O, Li₂S-P₂S₅-Li₂O-LiI, Li₂S-SiS₂ and Li₂S-SiS₂-LiI, Li₂S-SiS₂-LiBr, Li₂S-SiS₂-LiCl, Li₂S-SiS₂-B₂S₃-LiI, Li₂S-SiS₂-P₂S₅-LiI, Li₂S-B₂S₃, Li₂S-P₂S₅-ZₘSₙ (m and n being positive numbers, Z being Ge, Zn, or Ga), Li₂S-GeS₂ and Li₂S-SiS₂-Li₃PO₄, and Li₂S-SiS₂-LiₓMO_{y} (where x and y are positive numbers, M is P, Si, Ge, B, aluminum, Ga, or In etc.) The description of the above "Li₂S-P₂S₅" refers to sulfide solid electrolyte materials which use the material composition containing Li₂S and P₂S₅ in varying relative amounts, the same naming convention referring to other descriptions hereinabove. Particularly preferable solid electrolyte materials in the sulfide group are Li₇P₃S₁₁ and Li_{3.25}P_{0.95}S₄ and Li_{3.25}Ge_{0.25}P_{0.75}S₄.

Concerning the form of the solid electrolyte materials, examples include a particle shape, such as the shape of a true ball and the shape of an elliptical ball, or a thin film form, for example. When solid electrolyte materials have a particle shape, as for the mean particle diameter, it is preferable that their size is within the range of 50 nm to 5 micrometers, more preferably within the range of 100 nm to 3 micrometers.

Although it is preferable to have only one or more solid electrolyte materials as mentioned above in a solid electrolyte layer, this layer may also contain a binding agent if needed. As a binding agent used for a solid electrolyte layer, this may be of the same type as mentioned above for the positive active material layer.

As regards the thickness of a solid electrolyte layer, although this may change with the kind of solid electrolyte materials, and the overall composition of an all-solid battery, generally it is preferable that this thickness is within the range of 0.1 micrometer to 1000 micrometers, more preferably within the range of 0.1 micrometer to 300 micrometers.

As regards the negative electrode active material layer in the present invention, this layer at least contains one or more negative electrode active material(s), and may additionally contain at least one or more of solid electrolyte materials and electrically conductive agents if needed. When the all-solid-state batteries of the present invention are all-solid-state lithium batteries, the negative electrode active material is not limited provided that occlusion and discharge of the Li ion, which is a conduction ion, are possible. As a negative electrode active material, a carbon active material, a metal active material, etc. can be mentioned, for example. As a carbon active material, black lead, meso carbon micro beads (MCMB), highly ordered / oriented pyrolytic graphite (HOPG), hard carbon, soft carbon, etc. can be mentioned as examples. On the other hand, as a metal active material, charges of an alloy, such as Li alloy and Sn-Co-C, In, Al, Si, Sn, etc. can be mentioned as examples. Oxide stock materials, such as Li₄Ti₅O₁₂, can be mentioned as examples of other negative electrode active materials.

Concerning solid electrolyte materials used for the negative electrode active material layer, and an electrically conductive agent, these may be the same as that for the solid electrolyte layer and positive active material layer mentioned above.

The thickness of the negative electrode active material layer will generally be appropriately within the range of 0.1 micrometer to 1000 micrometers.

An all-solid-state battery of the present invention has at least the positive active material layer, solid electrolyte layer, and negative electrode active material layer which were mentioned above. It further usually has a positive pole collector which collects a positive active material layer, and a negative pole collector which performs current collection of a negative electrode active material layer. As a material of a positive pole collector, for example, SUS, aluminum, nickel, iron, titanium, carbon, etc. can be mentioned, and SUS is especially preferable. On the other hand as a material of a negative pole collector, SUS, copper, nickel, carbon, etc. can be mentioned, for example, and SUS is especially preferable. Concerning the thickness, form, etc. of a positive pole collector and a negative pole collector, the person skilled in the art may choose suitably according to the use of the all-solid-state battery, etc. The cell case used for a common all-solid-state battery can be used as the cell case used for the present invention, for example, the cell case made from SUS, etc. can be mentioned. The all-solid-state battery of the present invention may form a power generation element in the inside of an insulating ring.

The all-solid-state battery of the present invention can be considered as a chargeable and dischargeable all-solid-state battery in a room temperature environment. Although it may be a primary battery and may be a rechargeable battery as an all-solid-state battery of the present invention, it is especially preferable that it is a rechargeable battery. Concerning the form of the all-solid-state battery, a coin type, a laminated type, cylindrical, a square shape, etc. can be mentioned, as examples.

As regards the manufacturing method of the all-solid-state battery of the present invention, this is not particularly limited, and common manufacturing methods of all-solid-state batteries can be used. For example, when an all-solid-state battery is thin film form, a positive active material layer can be formed on a substrate, the modification material layer mentioned above on the positive active material layer can be formed, and the method of forming a solid electrolyte layer and a negative electrode active material layer in order, and laminating them thereafter etc., may be used.

Within the practice of the present invention, it may be envisaged to combine any features or embodiments which have hereinabove been separately set out and indicated to be advantageous, preferable, appropriate or otherwise generally applicable in the practice of the invention. The present description should be considered to include all such combinations of features or embodiments described herein unless such combinations are said herein to be mutually exclusive or are clearly understood in context to be mutually exclusive.

### Experimental section - Examples

The following experimental section illustrates experimentally the practice of the present invention, but the scope of the invention is not to be considered to be limited to the specific examples that follow.

### Method for the preparation of Li-Nb-Ta oxide thin films

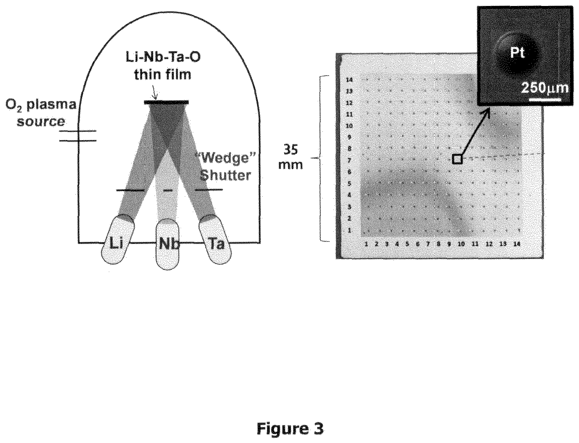

The method for the preparation of Li-Nb-Ta oxide thin films described herein is a "physical vapour" co-deposition of the component elements using an appropriate geometric arrangement of elemental sources in a UHV environment. The metallic elements (e.g. Li, Nb, Ta) are deposited using either Knudsen cells (K-cells) or Electron Beam Sources (e-guns). Oxygen (and other gaseous elements) is deposited using a plasma source. The presence of wedge shutters in the path of the elemental sources can be used to create thickness gradients of the component elements on the substrate. The rate of deposition is controlled by the temperature of the K-cell which is stable and reproducible. In an e-gun source, the power applied to the sample controls the deposition rate. In the case of plasma sources, the flow rate and plasma power control the deposition rate. The deposition rate as a function of position on the substrate is controlled by the wedge shutter. The incorporation of oxygen in the films is accomplished using a plasma atom source that converts O₂(g) into a flux of oxygen atoms, radicals, and ions directed at the substrate. The process is illustrated in Figure 3.

Typically, the evaporation temperatures used for the metal components in K-cells are those that achieve a vapour pressure of around 10⁻² Torr (1.33 Pa). Elements with deposition temperatures above around 1250°C are usually evaporated using electron beam sources to achieve appreciable deposition rates. Lithium (granules, 99.9%, Sigma Aldrich) was evaporated from a 40 cm³ pyrolytic boron nitride (PBN) crucible in a K-cell at temperatures ranging from 400 to 570°C. Niobium and Tantalum were evaporated using e-guns. Oxygen was incorporated into the films using an atom (i.e. plasma) source operating at a power ranging from 300 W to 600 W with an O₂(g) flow rate ranging from 1 to 5 sccm.

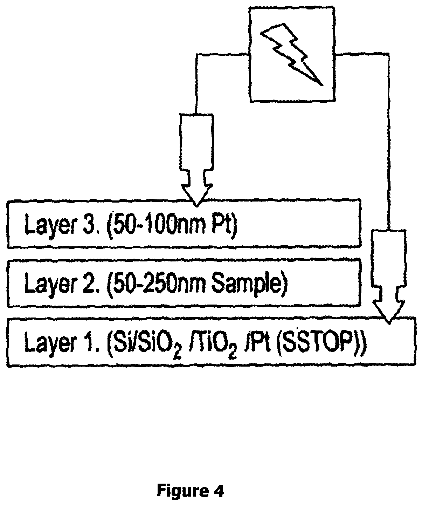

The substrates used throughout were 35 mm x 35 mm square wafers of approximately 1 mm thickness. The sample films were prepared on multilayer Si/SiO₂/TiO₂/Pt (SSTOP) (Nova Electronic Materials) at room temperature. The analysis of samples was carried out on a 14 x 14 grid with a pitch of 2.0 mm between analysis points. To facilitate through-film impedance measurements a 14 x 14 array of Pt contact pads with a diameter of 0.25 mm and a pitch of 2.0 mm were deposited using RF sputtering prior to removing the samples from the UHV system. The typical contact pad thickness was approximately 100 nm. The measurement process is illustrated in Figure 4. After making initial impedance measurements on the as deposited samples the samples were heated to 300, 350, 400, 450, 500, and 550°C in Ar atmosphere using a High Throughput Optical Mapping of Phase Transitions (HTOMPT) instrument designed and constructed in-house. In effect the HTOMPT instrument is a heated platen enclosed in a chamber with at view port located directly above the sample. Once assembled the chamber is air-tight and can be purged with inert gas (e.g., Ar) prior to heating the samples at a controlled rate.

The ionic conductivity was determined by measuring diameter of semi-arc observed at high frequency region in Nyquist plots, while the permittivity was determined at the frequency of 254 kHz. The protocol for making these measurements was as follows. Samples were transferred from either the UHV environment or the heating chamber (HTOMPT) and attached to a brass base plate with a small metal tab contacting to the surface of the platinum substrate to form a ground connection. The assembly was loaded onto the chuck of a Signatone probe station that was made insulating with a quartz plate and the enclosure was purged with Ar(g) throughout the measurements to reduce contact of the samples with the atmosphere. The platinum contact pads were addressed using a tungsten probe with a 25 µm tip diameter mounted on an arm that rotates in the vertical axis was used to ensure reproducible contact without piercing the films. The measurement process used to acquire impedance spectra from each point of the 14x14 array of samples is illustrated in Figure 4. Impedance spectra were recorded in the range of 10⁻⁶ Hz to 20 Hz with amplitude of 20 mV at each point using an Agilent 4284A Precision LCR Meter. The movement of the stage and operation of the LCR meter was coordinated and data recorded using in-house developed Labview® based instrument control software. The instrument recorded bias, frequency, modulus and phase data for each measurement. The data was imported into a Matlab® based informatics suite also developed in house for analysis according to the LEVM routine developed by J. Ross MacDonald {Impedance Spectroscopy: Theory, Experiment and Applications, 2nd Ed. E. Barsoukov (Editor) and J. Ross MacDonald (Editor),Wiley 2005 ISBN: 978-0-471-64749-2}. Permittivity values were calculated at 254 kHz to reduce the impact of electrode polarization on the observed values. Conductivities were determined from the observed impedances (diameter of semi-arc observed) by corrected using a geometric factor that is the ratio of the film thickness to the area of the platinum contact pad.

The elemental compositions of samples were measured by Laser Ablation Inductively Coupled Plasma Mass Spectroscopy (ICP-MS) using a Perkin Elmer Elan 9000 ICP-MS equipped with a New Wave 213 nm laser. The ICP-MS analysis was done with reference to NIST 610 standard reference material.

The sample thicknesses were measured by ellipsometry (Woollam M-200FI Spectroscopic Ellipsometer). The crystalline phase compositions were determined by X-ray diffraction (Bruker D8 diffractometer system equipped with a GADDS detector and a high intensity point source). The 2θ values quoted herein were measured using Cu Kα radiation. A typical collection was done using a 2θ range from 20 to 52° and a collection time of 4 minutes for each field of a 14 x 14 array sample. The phase composition for the samples was also determined using Raman Spectroscopy (HORIBA Xplora). The use of XRD and Raman spectroscopy provides complementary information about crystalline and amorphous phases in the deposited materials.

### Results

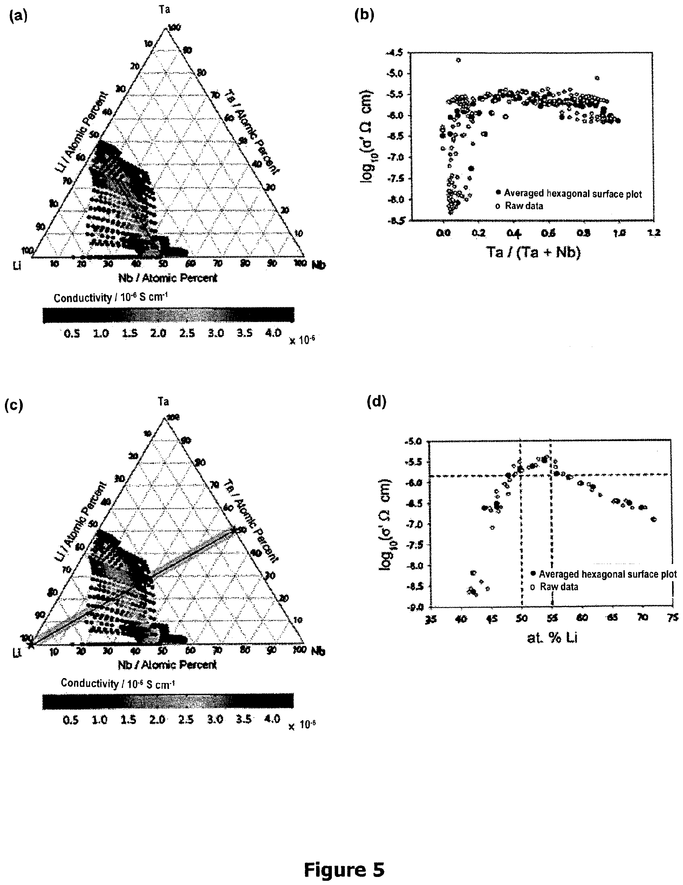

The Figure 5 below shows ionic conductivities as a function of chemical composition of Li-Nb-Ta. The samples were annealed at 450°C. Figure 5(b) indicates that their ionic conductivity do not change dramatically when Ta / (Ta + Nb) ratio exceeds 0.2. On the other hand, Figure 5(d) suggests that the ionic conductivity strongly depends on Li concentration; particularly Li concentration between 0.50 and 0.55 has unexpected increase in ionic conductivity when the composition is Ta:Nb = 50:50. This trend was surprising because, as shown in prior art reference [3], Li_{0.55}Nb_{0.45}O₃ has lower ionic conductivity than LiNbO₃.

Next, as comparison examples, ionic conductivity and permittivity of LiNbO₃ and LiTaO₃ were measured. The results are summarized in Table 0.

**Table 0. Comparison examples (the samples were annealed at 400 or 450°C)**

| | | | | Annealed at 400°C | | Annealed at 450°C | |
|---|---|---|---|---|---|---|---|
| Sample No. | Chemical composition | | | Ionic conductivity (S/cm) | Permittivity at 254 kHz | Ionic conductivity (S/cm) | Permittivity at 254 kHz |
| | Li (at. %) | Ta (at. %) | Nb (at. %) | | | | |
| 0-1 | 50 | 0 | 50 | 1.8 x 10⁻⁶ | 95 | 4.5 x 10⁻⁷ | 50 |
| 0-2 | 50 | 50 | 0 | 7.3 x 10⁻⁷ | 94 | 7.2 x 10⁻⁷ | 98 |

In what follows, Examples according to the invention are ones showing ternary Li-Nb-Ta oxides having from 53 to 56 atom % of Li, from 15 to 30 atom % of Nb, and from 17 to 29 atom % of Ta.

### Examples (samples annealed at 400°C)

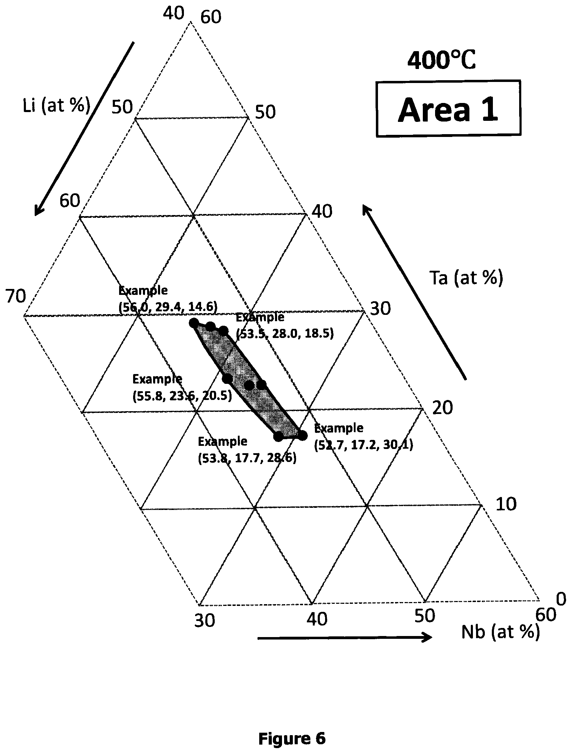

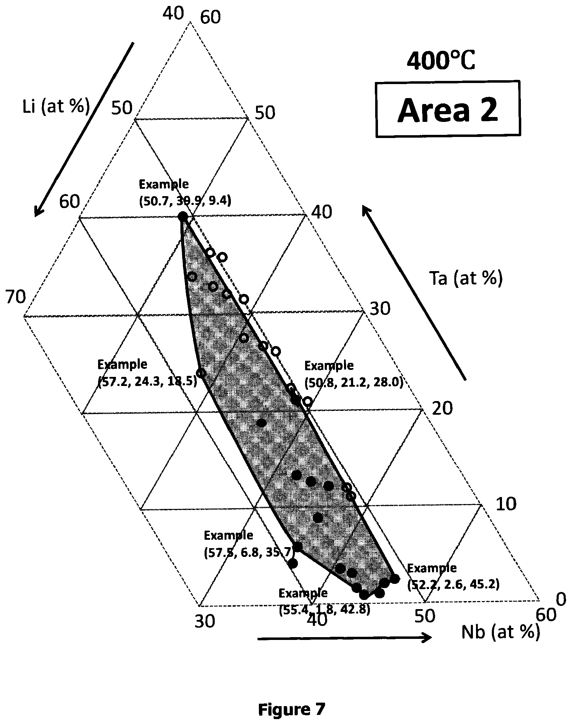

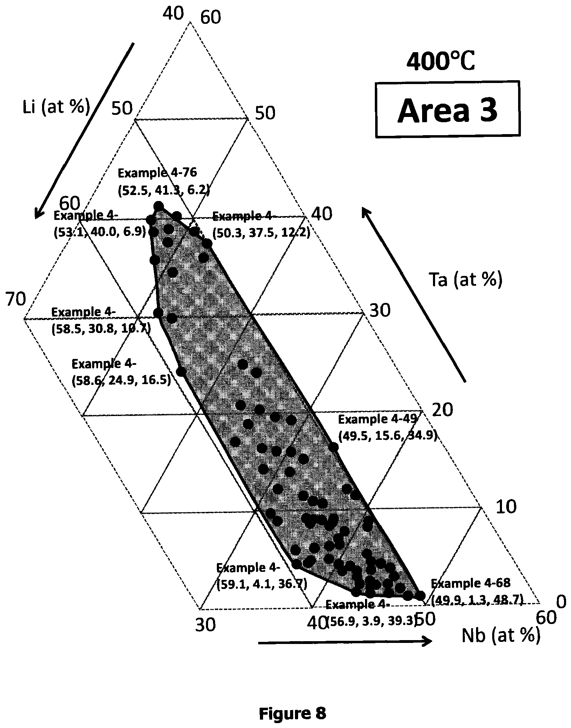

As will be explained later, annealing temperatures of 400 or 450°C were most effective to achieve both high ionic conductivity and high permittivity at the same time. In this section, the results of the samples annealed at 400°C are shown.
Table 1 and Fig. 6 summarize data assigned in the compositional range of Area 1.
Table 2 and Table 3 and Fig. 7 summarize data assigned in the compositional range of Area 2.
Table 4 and Fig. 8 summarize data assigned in compositional range of Area 3.

**Table 1. Samples showing ionic conductivity larger than 3.5 x 10⁻⁶ S/cm and permittivity larger than 150. (The samples were annealed at 400°C.)**

| Sample No. | Chemical composition | | | Ionic conductivity (S/cm) | Permittivity at 254 kHz |
|---|---|---|---|---|---|
| | Li (at. %) | Ta (at. %) | Nb (at. %) | | |
| 1-1 | 54.4 | 23.0 | 22.5 | 4.2 x 10⁻⁶ | 165.4 |
| 1-2 | 53.8 | 17.7 | 28.6 | 4.1 x 10⁻⁶ | 156.1 |
| 1-3 | 55.8 | 23.6 | 20.5 | 4.0 x 10⁻⁶ | 158.2 |
| 1-4 | 52.7 | 17.2 | 30.1 | 4.0 x 10⁻⁶ | 158.0 |
| 1-5 | 54.7 | 28.7 | 16.5 | 4.0 x 10⁻⁶ | 163.0 |
| 1-6 | 53.5 | 28.0 | 18.5 | 3.8 x 10⁻⁶ | 167.4 |
| 1-7 | 56.0 | 29.4 | 14.6 | 3.7 x 10⁻⁶ | 151.7 |
| 1-8 | 53.0 | 22.4 | 24.6 | 3.6 x 10⁻⁶ | 163.1 |

**Table 2. Samples exhibiting ionic conductivity σ > 3.5 x 10⁻⁶ S/cm and permittivity 100 < ε < 150. (The samples were annealed at 400°C)**

| Sample No. | Chemical composition | | | Ionic conductivity (S/cm) | Permittivity at 254 kHz |
|---|---|---|---|---|---|
| | Li (at. %) | Ta (at. %) | Nb (at. %) | | |
| 2-9 | 50.0 | 2.1 | 47.8 | 6.5 x 10⁻⁶ | 110.1 |
| 2-10 | 50.7 | 39.9 | 9.4 | 5.4 x 10⁻⁶ | 115.8 |
| 2-11 | 53.5 | 12.7 | 33.8 | 4.0 x 10⁻⁶ | 147.1 |
| 2-12 | 54.6 | 13.1 | 32.3 | 3.8 x 10⁻⁶ | 142.2 |
| 2-13 | 55.1 | 18.2 | 26.7 | 5.4 x 10⁻⁶ | 147.1 |
| 2-14 | 56.3 | 4.0 | 39.8 | 3.6 x 10⁻⁶ | 106.4 |
| 2-15 | 55.4 | 1.8 | 42.8 | 3.6 x 10⁻⁶ | 106.9 |
| 2-16 | 52.4 | 12.3 | 35.3 | 3.6 x 10⁻⁶ | 143.8 |
| 2-17 | 55.7 | 2.5 | 41.8 | 3.5 x 10⁻⁶ | 103.1 |
| 2-18 | 56.0 | 3.3 | 40.8 | 3.5 x 10⁻⁶ | 102.3 |
| 2-19 | 55.3 | 8.8 | 35.9 | 3.5 x 10⁻⁶ | 128.0 |

**Table 3. Samples exhibiting ionic conductivity 2 x 10⁻⁶ S/cm < σ < 3.5 x 10⁻⁶ S/cm and permittivity ε > 150. (The samples were annealed at 400°C)**

| Sample No. | Chemical composition | | | Ionic conductivity (S/cm) | Permittivity at 254 kHz |
|---|---|---|---|---|---|
| | Li (at. %) | Ta (at. %) | Nb (at. %) | | |
| 3-1 | 51.8 | 21.8 | 26.4 | 3.4 x 10⁻⁶ | 165.1 |
| 3-2 | 53.3 | 34.0 | 12.7 | 3.4 x 10⁻⁶ | 160.7 |
| 3-3 | 57.2 | 24.3 | 18.5 | 3.3 x 10⁻⁶ | 155.1 |
| 3-4 | 52.2 | 27.3 | 20.4 | 3.3 x 10⁻⁶ | 167.2 |
| 3-5 | 51.7 | 16.6 | 31.7 | 3.3 x 10⁻⁶ | 155.2 |
| 3-6 | 52.2 | 33.2 | 14.6 | 3.2 x 10⁻⁶ | 159.5 |
| 3-7 | 50.8 | 21.2 | 28.0 | 3.0 x 10⁻⁶ | 164.3 |
| 3-8 | 50.6 | 16.1 | 33.3 | 3.0 x 10⁻⁶ | 159.0 |
| 3-9 | 51.0 | 26.6 | 22.4 | 2.7 x 10⁻⁶ | 162.3 |
| 3-10 | 51.1 | 32.4 | 16.5 | 2.7 x 10⁻⁶ | 165.0 |
| 3-11 | 49.8 | 20.6 | 29.6 | 2.6 x 10⁻⁶ | 166.4 |
| 3-12 | 49.9 | 25.9 | 24.2 | 2.5 x 10⁻⁶ | 169.3 |
| 3-13 | 50.7 | 36.1 | 13.1 | 2.5 x 10⁻⁶ | 154.4 |
| 3-14 | 50.0 | 31.6 | 18.3 | 3.6 x 10⁻⁶ | 166.6 |
| 3-15 | 48.9 | 25.2 | 25.9 | 2.1 x 10⁻⁶ | 162.6 |
| 3-16 | 48.8 | 20.0 | 31.2 | 2.1 x 10⁻⁶ | 158.5 |
| 3-17 | 49.7 | 35.3 | 15.0 | 2.0 x 10⁻⁶ | 155.6 |

**Table 4. Samples exhibiting ionic conductivity between 2 x 10⁻⁶ S/cm < σ < 3.5 x 10⁻⁶ S/cm and permittivity between 100 < ε < 150. (The samples were annealed at 400°C.)**

| Sample No. | Chemical composition | | | Ionic conductivity (S/cm) | Permittivity at 254 kHz |
|---|---|---|---|---|---|
| | Li (at. %) | Ta (at. %) | Nb (at. %) | | |
| 4-1 | 52.7 | 37.8 | 9.5 | 3.4 x 10⁻⁶ | 129.2 |
| 4-2 | 54.1 | 8.5 | 37.4 | 3.4 x 10⁻⁶ | 133.1 |
| 4-3 | 54.7 | 1.7 | 43.6 | 3.3 x 10⁻⁶ | 109.7 |
| 4-4 | 55.3 | 3.9 | 40.8 | 3.3 x 10⁻⁶ | 103.6 |
| 4-5 | 56.3 | 6.7 | 37.0 | 3.2 x 10⁻⁶ | 100.4 |
| 4-6 | 55.7 | 11.8 | 32.5 | 3.2 x 10⁻⁶ | 128.7 |
| 4-7 | 55.5 | 4.7 | 39.8 | 3.1 x 10⁻⁶ | 100.4 |
| 4-8 | 53.0 | 8.2 | 38.8 | 3.1 x 10⁻⁶ | 126.3 |
| 4-9 | 55.9 | 4.7 | 39.4 | 3.1 x 10⁻⁶ | 119.1 |
| 4-10 | 54.9 | 2.5 | 42.7 | 3.1 x 10⁻⁶ | 103.7 |
| 4-11 | 55.1 | 3.2 | 41.7 | 3.1 x 10⁻⁶ | 100.1 |
| 4-12 | 57.2 | 30.1 | 12.7 | 3.1 x 10⁻⁶ | 129.1 |
| 4-13 | 54.8 | 6.0 | 39.2 | 3.1 x 10⁻⁶ | 108.6 |
| 4-14 | 54.7 | 4.5 | 40.8 | 3.0 x 10⁻⁶ | 124.2 |
| 4-15 | 54.7 | 11.5 | 33.9 | 3.0 x 10⁻⁶ | 130.1 |
| 4-16 | 55.3 | 15.8 | 28.8 | 3.0 x 10⁻⁶ | 126.3 |
| 4-17 | 54.7 | 6.1 | 39.2 | 3.0 x 10⁻⁶ | 120.8 |
| 4-18 | 54.4 | 34.8 | 10.8 | 3.0 x 10⁻⁶ | 130.2 |
| 4-19 | 55.7 | 13.5 | 30.7 | 2.9 x 10⁻⁶ | 136.9 |
| 4-20 | 55.8 | 9.0 | 35.2 | 2.9 x 10⁻⁶ | 120.4 |
| 4-21 | 55.7 | 3.7 | 40.6 | 2.9 x 10⁻⁶ | 116.4 |
| 4-22 | 56.9 | 3.9 | 39.3 | 2.9 x 10⁻⁶ | 119.2 |
| 4-23 | 54.7 | 8.7 | 36.6 | 2.9 x 10⁻⁶ | 117.7 |
| 4-24 | 53.2 | 0 | 46.8 | 2.9 x 10⁻⁶ | 104.1 |
| 4-25 | 56.5 | 9.1 | 34.4 | 2.8 x 10⁻⁶ | 122.3 |
| 4-26 | 54.3 | 3.9 | 41.8 | 2.8 x 10⁻⁶ | 103.0 |
| 4-27 | 57.2 | 4.9 | 38.0 | 2.8 x 10⁻⁶ | 112.3 |
| 4-28 | 54.1 | 2.4 | 43.5 | 2.8 x 10⁻⁶ | 102.4 |
| 4-29 | 54.1 | 15.3 | 30.6 | 2.8 x 10⁻⁶ | 130.9 |
| 4-30 | 51.2 | 11.9 | 36.9 | 2.8 x 10⁻⁶ | 131.8 |
| 4-31 | 56.9 | 6.5 | 36.6 | 2.8 x 10⁻⁶ | 115.8 |
| 4-32 | 52.5 | 0 | 47.5 | 2.7 x 10⁻⁶ | 101.8 |
| 4-33 | 53.5 | 4.3 | 42.3 | 2.7 x 10⁻⁶ | 122.6 |
| 4-34 | 56.9 | 9.2 | 33.9 | 2.7 x 10⁻⁶ | 119.0 |
| 4-35 | 53.6 | 8.5 | 37.9 | 2.7 x 10⁻⁶ | 117.7 |
| 4-36 | 57.1 | 12.3 | 30.7 | 2.7 x 10⁻⁶ | 120.9 |
| 4-37 | 53.6 | 11.1 | 35.2 | 2.6 x 10⁻⁶ | 125.3 |
| 4-38 | 51.8 | 7.9 | 40.3 | 2.6 x 10⁻⁶ | 120.6 |
| 4-39 | 51.7 | 36.9 | 11.3 | 2.6 x 10⁻⁶ | 139.9 |
| 4-40 | 56.7 | 16.4 | 26.9 | 2.6 x 10⁻⁶ | 113.4 |
| 4-41 | 54.6 | 20.4 | 25.0 | 2.5 x 10⁻⁶ | 114.1 |
| 4-42 | 51.7 | 1.9 | 46.4 | 2.5 x 10⁻⁶ | 105.2 |
| 4-43 | 53.7 | 38.6 | 7.7 | 2.5 x 10⁻⁶ | 114.7 |
| 4-44 | 55.5 | 35.6 | 9.0 | 2.5 x 10⁻⁶ | 109.1 |
| 4-45 | 53.8 | 6.5 | 39.7 | 2.5 x 10⁻⁶ | 101.5 |
| 4-46 | 53.2 | 2.4 | 44.4 | 2.6 x 10⁻⁶ | 102.1 |
| 4-47 | 53.3 | 3.1 | 43.6 | 2.5 x 10⁻⁶ | 100.1 |
| 4-48 | 51.5 | 4.2 | 44.3 | 2.4 x 10⁻⁶ | 100.6 |
| 4-49 | 49.5 | 15.6 | 34.9 | 2.4 x 10⁻⁶ | 145.7 |
| 4-50 | 53.0 | 14.9 | 32.1 | 2.4 x 10⁻⁶ | 128.2 |
| 4-51 | 53.4 | 19.7 | 26.9 | 2.4 x10⁶ | 122.5 |
| 4-52 | 58.6 | 24.9 | 16.5 | 2.4 x 10⁻⁶ | 139.5 |
| 4-53 | 55.9 | 21.0 | 23.2 | 2.3 x 10⁻⁶ | 105.1 |
| 4-54 | 52.2 | 4.0 | 43.7 | 2.3 x 10⁻⁶ | 118.0 |
| 4-55 | 50.1 | 11.5 | 38.4 | 2.3 x 10⁻⁶ | 127.1 |
| 4-56 | 58.2 | 9.6 | 32.1 | 2.3 x 10⁻⁶ | 111.2 |
| 4-57 | 52.4 | 1.6 | 45.9 | 2.3 x 10⁻⁶ | 103.1 |
| 4-58 | 58.0 | 6.7 | 35.3 | 2.3 x 10⁻⁶ | 111.7 |
| 4-59 | 52.4 | 2.3 | 45.2 | 2.3 x 10⁻⁶ | 100.4 |
| 4-60 | 52.6 | 10.8 | 36.6 | 2.2 x 10⁻⁶ | 119.9 |
| 4-61 | 50.6 | 7.6 | 41.8 | 2.2 x 10⁻⁶ | 122.4 |
| 4-62 | 53.7 | 25.0 | 21.3 | 2.2 x 10⁻⁶ | 108.1 |
| 4-63 | 58.5 | 12.8 | 28.7 | 2.2 x 10⁻⁶ | 110.3 |
| 4-64 | 52.4 | 3.7 | 43.9 | 2.2 x 10⁻⁶ | 101.3 |
| 4-65 | 57.1 | 14.0 | 28.9 | 2.2 x 10⁻⁶ | 127.9 |
| 4-66 | 59.1 | 4.1 | 36.7 | 2.2 x 10⁻⁶ | 105.6 |
| 4-67 | 52.2 | 39.1 | 8.7 | 2.2 x 10⁻⁶ | 121.1 |
| 4-68 | 49.9 | 1.3 | 48.7 | 2.1 x 10⁻⁶ | 106.6 |
| 4-69 | 53.1 | 40.0 | 6.9 | 2.1 x 10⁻⁶ | 107.5 |
| 4-70 | 52.4 | 4.4 | 4.2 | 2.1 x 10⁻⁶ | 100.5 |
| 4-71 | 51.7 | 1.6 | 46.7 | 2.1 x 10⁻⁶ | 102.3 |
| 4-72 | 56.6 | 18.7 | 24.6 | 2.1 x 10⁻⁶ | 137.7 |
| 4-73 | 51.5 | 3.0 | 45.5 | 2.1 x 10⁻⁶ | 104.0 |
| 4-74 | 52.6 | 24.3 | 23.1 | 2.1 x 10⁻⁶ | 114.4 |
| 4-75 | 58.0 | 17.0 | 25.0 | 2.0 x 10⁻⁶ | 100.4 |
| 4-76 | 52.5 | 41.3 | 6.2 | 2.0 x 10⁻⁶ | 110.2 |
| 4-77 | 52.2 | 19.1 | 28.7 | 2.0 x 10⁻⁶ | 122.9 |
| 4-78 | 53.6 | 3.2 | 43.3 | 2.0 x 10⁻⁶ | 103.3 |
| 4-79 | 51.6 | 40.5 | 7.9 | 2.0 x 10⁻⁶ | 119.1 |
| 4-80 | 53.6 | 2.6 | 43.8 | 2.0 x 10⁻⁶ | 102.5 |
| 4-81 | 51.5 | 3.7 | 44.9 | 2.0 x 10⁻⁶ | 103.6 |
| 4-82 | 50.9 | 1.6 | 47.5 | 2.0 x 10⁻⁶ | 104.3 |
| 4-83 | 57.7 | 9.4 | 32.9 | 2.0 x 10⁻⁶ | 114.8 |
| 4-84 | 50.3 | 37.5 | 12.2 | 2.0 x 10⁻⁶ | 143.9 |
| 4-85 | 51.2 | 38.3 | 10.5 | 2.0 x 10⁻⁶ | 130.3 |

### Examples (samples annealed at 450°C)

In this section, the results of the samples annealed at 450°C are shown.

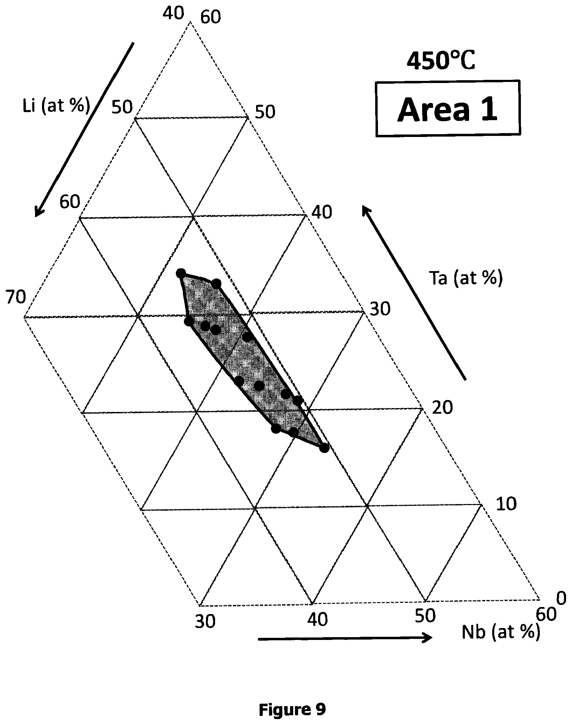

Table 5 and Figure 9 summarize data assigned in the compositional range of Area 1.

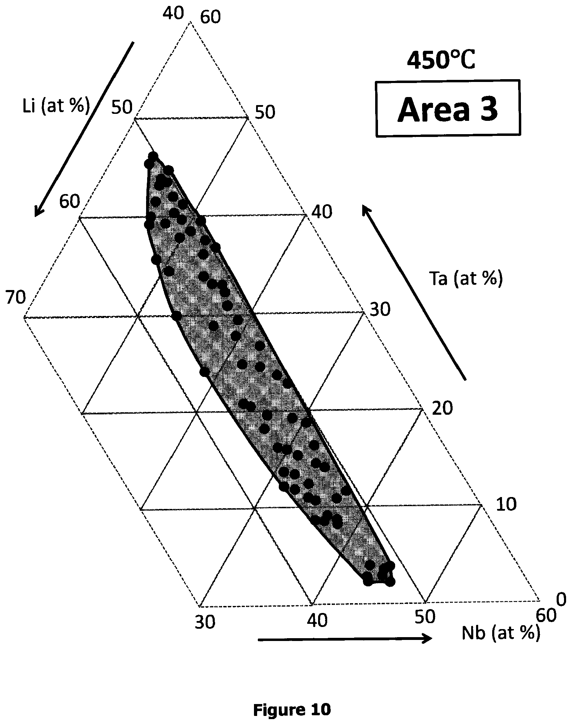

Table 6 and Figure 10 summarize data assigned in the compositional range of Area 3.

The number of samples assigned as Area 2 was small, therefore the Area 2 is not presented in this case.

**Table 5. Samples showing ionic conductivity larger than 3.5 x 10⁻⁶ S/cm and permittivity larger than 150. (The samples were annealed at 450°C.)**

| Sample No. | Chemical composition | | | Ionic conductivity (S/cm) | Permittivity at 254 kHz |
|---|---|---|---|---|---|
| | Li (at. %) | Ta (at. %) | Nb (at. %) | | |
| 5-1 | 53.8 | 17.7 | 28.6 | 3.5 x 10⁻⁶ | 155.0 |
| 5-2 | 50.8 | 21.2 | 28.0 | 3.5 x 10⁻⁶ | 167.1 |
| 5-3 | 53.0 | 22.4 | 24.6 | 3.6 x 10⁻⁶ | 159.0 |
| 5-4 | 56.0 | 29.4 | 14.6 | 3.6 x 10⁻⁶ | 152.0 |
| 5-5 | 51.7 | 16.6 | 31.7 | 3.7 x 10⁻⁶ | 154.4 |
| 5-6 | 52.2 | 33.2 | 14.6 | 3.7 x 10⁻⁶ | 161.7 |
| 5-7 | 51.8 | 21.8 | 26.4 | 3.7 x 10⁻⁶ | 161.3 |
| 5-8 | 52.2 | 27.3 | 20.4 | 4.0 x 10⁻⁶ | 172.8 |
| 5-9 | 54.7 | 28.7 | 16.5 | 4.1 x 10⁻⁶ | 166. |
| 5-10 | 54.4 | 23.0 | 22.5 | 4.1 x 10⁻⁶ | 164.1 |
| 5-11 | 53.3 | 34.0 | 12.7 | 4.1 x 10⁻⁶ | 164.8 |
| 5-12 | 52.7 | 17.2 | 30.1 | 4.2 x 10⁻⁶ | 158.8 |
| 5-13 | 53.5 | 28.0 | 18.5 | 4.3 x 10⁻⁶ | 170.6 |

**Table 6. Samples exhibiting ionic conductivity between 2 x 10⁻⁶ S/cm < σ < 3.5 x 10⁻⁶ S/cm and permittivity between 100 < ε < 150. (The samples were annealed at 450°C.)**

| Sample No. | Chemical composition | | | Ionic conductivity (S/cm) | Permittivity at 254 kHz |
|---|---|---|---|---|---|
| | Li (at. %) | Ta (at. %) | Nb (at. %) | | |
| 6-1 | 57.1 | 12.3 | 30.7 | 2.0 x 10⁻⁶ | 111.9 |
| 6-2 | 51.3 | 33.2 | 15.5 | 2.0 x 10⁻⁶ | 101.8 |
| 6-3 | 50.4 | 22.9 | 26.7 | 2.0 x 10⁻⁶ | 120.3 |
| 6-4 | 49.8 | 38.9 | 11.3 | 2.0 x 10⁻⁶ | 131.0 |
| 6-5 | 50.5 | 43.2 | 6.3 | 2.0 x 10⁻⁶ | 111.5 |
| 6-6 | 51.0 | 32.6 | 16.4 | 2.0 x 10⁻⁶ | 107.7 |
| 6-7 | 51.7 | 30.8 | 17.5 | 2.0 x 10⁻⁶ | 10.9 |
| 6-8 | 51.5 | 32.1 | 16.4 | 2.0 x 10⁻⁶ | 101.4 |
| 6-9 | 49.9 | 44.6 | 5.5 | 2.1 x 10⁻⁶ | 111.4 |
| 6-10 | 50.1 | 46.7 | 3.2 | 2.1 x 10⁻⁶ | 105.3 |
| 6-11 | 51.4 | 27.0 | 21.6 | 2.1 x 10⁻⁶ | 110.1 |
| 6-12 | 53.4 | 3.7 | 42.9 | 2.1 x 10⁻⁶ | 102.4 |
| 6-13 | 51.2 | 18.6 | 30.2 | 2.1 x 10⁻⁶ | 126.1 |
| 6-14 | 50.2 | 41.0 | 8.7 | 2.1 x 10⁻⁶ | 121.1 |
| 6-15 | 55.7 | 33.3 | 13.9 | 2.1 x 10⁻⁶ | 129.3 |
| 6-16 | 52.1 | 33.2 | 14.7 | 2.2 x 10⁻⁶ | 101.0 |
| 6-17 | 52.4 | 33.8 | 13.8 | 2.2 x 10⁻⁶ | 100.3 |
| 6-18 | 49.4 | 36.7 | 14.0 | 2.2 x 10⁻⁶ | 150.8 |
| 6-19 | 56.7 | 16.4 | 26.9 | 2.2 x 10⁻⁶ | 108.7 |
| 6-20 | 52.0 | 29.3 | 18.7 | 2.2 x 10⁻⁶ | 106.0 |
| 6-21 | 51.1 | 41.9 | 7.1 | 2.2 x 10⁻⁶ | 113.9 |
| 6-22 | 53.6 | 3.2 | 43.3 | 2.2 x 10⁻⁶ | 104.5 |
| 6-23 | 536 | 2.6 | 43.8 | 2.2 x 10⁻⁶ | 104.3 |
| 6-24 | 54.7 | 8.7 | 36.6 | 2.2 x 10⁻⁶ | 113.0 |
| 6-25 | 52.0 | 14.5 | 33.6 | 2.2 x 10⁻⁶ | 122.8 |
| 6-26 | 53.6 | 28.4 | 18.0 | 2.2 x 10⁻⁶ | 100.1 |
| 6-27 | 50.7 | 45.4 | 3.9 | 2.2 x 10⁻⁶ | 109.2 |
| 6-28 | 51.3 | 44.0 | 4.7 | 2.3 x 10⁻⁶ | 108.3 |
| 6-29 | 51.5 | 23.6 | 24.9 | 2.3 x 10⁻⁶ | 115.8 |
| 6-30 | 50.7 | 39.7 | 9.6 | 2.3 x 10⁻⁶ | 127.7 |
| 6-31 | 53.6 | 8.5 | 37.9 | 2.3 x 10⁻⁶ | 111.1 |
| 6-32 | 55.9 | 21.0 | 23.2 | 2.3 x 10⁻⁶ | 102.5 |
| 6-33 | 55.1 | 18.2 | 26.7 | 2.3 x 10⁻⁶ | 140.7 |
| 6-34 | 55.3 | 8.8 | 35.9 | 2.3 x 10⁻⁶ | 123.2 |
| 6-35 | 52.6 | 10.8 | 36.6 | 2.3 x 10⁻⁶ | 118.5 |
| 6-36 | 52.4 | 27.7 | 19.8 | 2.4 x 10⁻⁶ | 106.5 |
| 6-37 | 52.2 | 4.3 | 43.5 | 2.4 x 10⁻⁶ | 101.6 |
| 6-38 | 52.4 | 3.1 | 44.5 | 2.4 x 10⁻⁶ | 101.2 |
| 6-39 | 51.9 | 42.7 | 5.4 | 2.4 x 10⁻⁶ | 114.2 |
| 6-40 | 50.3 | 37.5 | 12.2 | 2.4 x 10⁻⁶ | 146.4 |
| 6-41 | 52.4 | 3.7 | 43.9 | 2.4 x 10⁻⁶ | 101.8 |
| 6-42 | 57.2 | 30.1 | 12.7 | 2.5 x 10⁻⁶ | 127.0 |
| 6-43 | 52.2 | 19.1 | 28.7 | 2.5 x 10⁻⁶ | 123.8 |
| 6-44 | 53.0 | 8.2 | 38.8 | 2.5 x 10⁻⁶ | 123.3 |
| 6-45 | 51.6 | 40.5 | 7.9 | 2.5 x 10⁻⁶ | 123.9 |
| 6-46 | 53.7 | 25.0 | 21.3 | 2.5 x 10⁻⁶ | 109.3 |
| 6-47 | 51.2 | 38.3 | 10.5 | 2.5 x 10⁻⁶ | 135.9 |
| 6-48 | 52.5 | 41.3 | 6.2 | 2.5 x 10⁻⁶ | 113.0 |
| 6-49 | 52.6 | 24.3 | 23.1 | 2.6 x 10⁻⁶ | 115.3 |
| 6-50 | 57.2 | 24.3 | 18.5 | 2.6 x 10⁻⁶ | 150.5 |
| 6-51 | 53.1 | 40.0 | 6.9 | 2.7 x 10⁻⁶ | 113.5 |
| 6-52 | 54.1 | 8.5 | 37.4 | 2.7 x 10⁻⁶ | 125.4 |
| 6-53 | 52.2 | 39.1 | 8.7 | 2.7 x 10⁻⁶ | 123.6 |
| 6-54 | 55.7 | 11.8 | 32.5 | 2.7 x 10⁻⁶ | 125.3 |
| 6-55 | 51.2 | 11.9 | 36.9 | 2.7 x 10⁻⁶ | 131.0 |
| 6-56 | 55.5 | 35.6 | 9.0 | 2.7 x 10⁻⁶ | 110.9 |
| 6-57 | 54.6 | 20.4 | 25.0 | 2.7 x 10⁻⁶ | 115.6 |
| 6-58 | 54.6 | 13.1 | 32.3 | 2.7 x 10⁻⁶ | 135.4 |
| 6-59 | 51.5 | 4.2 | 44.3 | 2.7 x 10⁻⁶ | 102.8 |
| 6-60 | 53.0 | 14.9 | 32.1 | 2.8 x 10⁻⁶ | 129.2 |
| 6-61 | 53.7 | 38.6 | 7.7 | 2.8 x 10⁻⁶ | 114.0 |
| 6-62 | 53.4 | 19.7 | 26.9 | 2.9 x 10⁻⁶ | 124.3 |
| 6-63 | 53.6 | 11.1 | 35.2 | 2.9 x 10⁻⁶ | 123.8 |
| 6-64 | 52.7 | 37.8 | 9.5 | 2.9 x 10⁻⁶ | 125.7 |
| 6-65 | 55.3 | 15.8 | 28.8 | 2.9 x 10⁻⁶ | 121.7 |
| 6-66 | 54.7 | 11.5 | 33.9 | 3.0 x 10⁻⁶ | 127.6 |
| 6-67 | 54.1 | 15.3 | 30.6 | 3.0 x 10⁻⁶ | 127.6 |
| 6-68 | 51.7 | 36.9 | 11.3 | 3.1 x 10⁻⁶ | 144.8 |
| 6-69 | 53.5 | 12.7 | 33.8 | 3.1 x 10⁻⁶ | 142.0 |
| 6-70 | 54.4 | 34.8 | 10.8 | 3.3 x 10⁻⁶ | 134.1 |
| 6-71 | 52.4 | 12.3 | 35.3 | 3.4 x 10⁻⁶ | 140.1 |

### The effect of annealing temperature

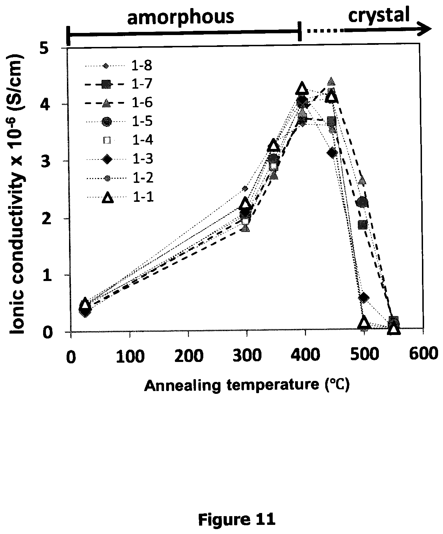

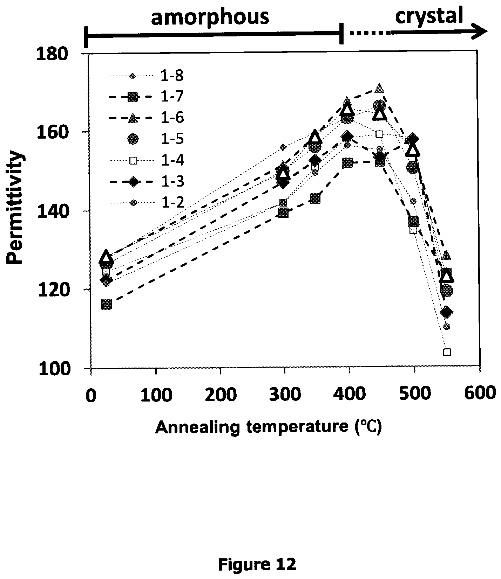

The effect of annealing temperatures was studied. As shown in Figs. 11 and 12, annealing at around 400 and 450°C, using the annealing chamber setup used in the present series of experiments, could offer maximum ionic conductivity as well as permittivity at the same time. This is probably because morphologies in materials are most appropriate for lithium-ion conduction when annealed at these temperatures. As will be shown later, these materials have an amorphous state or partially crystalline state.

It is generally known that LiNbO₃ and LiTaO₃ in an amorphous state exhibit ionic conductivity with almost no permittivity, whereas in their crystal state they exhibit large permittivity with no conductivity. Therefore, it was unexpected that the materials of the present invention would exhibit both the highest ionic conductivity and permittivity when they are annealed at around 400 and 450°C.

### Characterization of crystallinity in samples

The samples were analyzed by XRD, Raman, and TEM to obtain further structural information. The XRD analysis confirmed that the materials have crystal structure assigned as a space group of R3c(161) with a rhombohedral lattice.

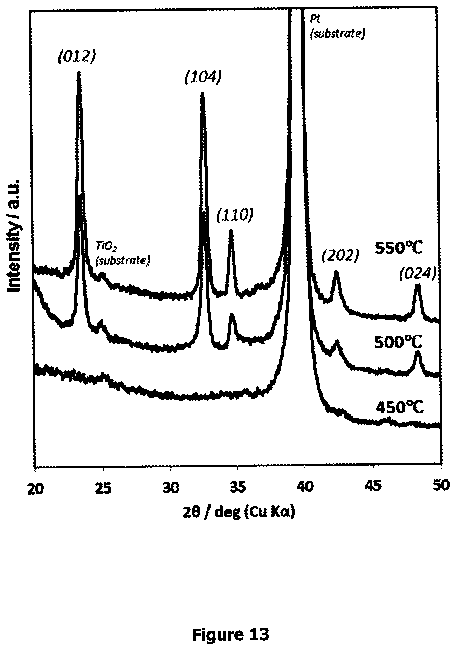

As shown in Fig. 13, the peak strength increased as annealing temperature increased, indicating that crystallinity increased as annealing temperature increased. No remarkable peaks were observed for samples annealed at temperatures below 450°C, indicating that those samples are in an almost amorphous state.

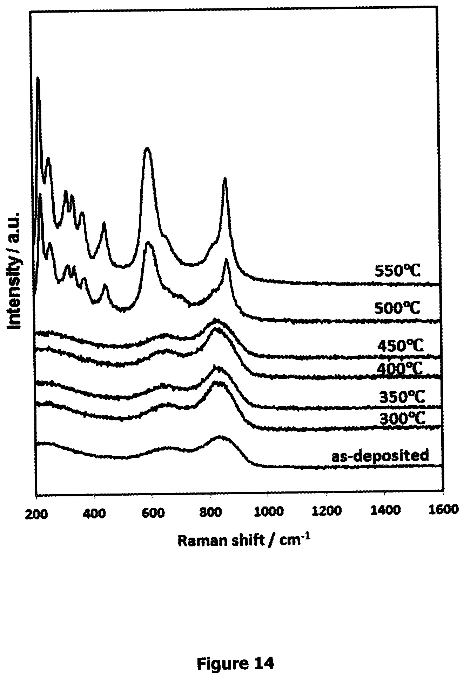

The Raman spectra in Fig. 14 also suggests that the crystallinity of the sample increased as annealing temperatures increased above 500°C. No remarkable peaks were observed for samples annealed at temperatures less than 450°C, indicating that they are in an almost amorphous state.

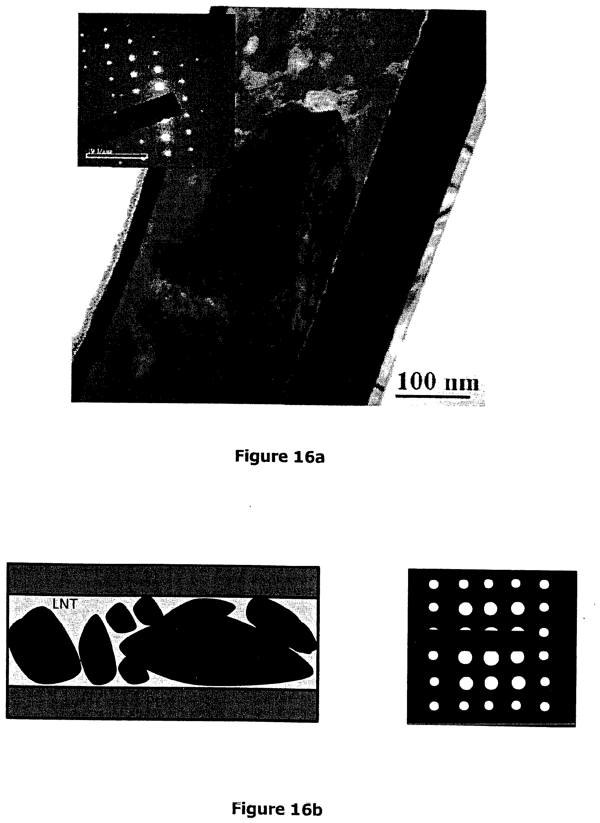

TEM images were taken to observe morphology and crystallinity in samples. When the sample was annealed at 550°C, clear spots were observed in electron diffraction patterns as shown in Fig. 16, indicating that the sample consists of crystal phases. Such crystals had small ionic conductivity and permittivity. On the other hand, the electron diffraction patterns showed weak spots due to small crystallines when annealed at 450°C as shown in Fig. 15. It may be noted that the intensity of electron diffraction spots depended on chemical composition; in fact, no spot was observed in Fig. 17 even though the annealed temperature was 450°C.

As was shown in Fig. 11 and 12, samples annealed at around 400 and 450°C are embodiments within the scope of the present invention. As a result of the TEM analysis, these materials seem to have amorphous state or partially crystalline state.

### Fabrication of a battery

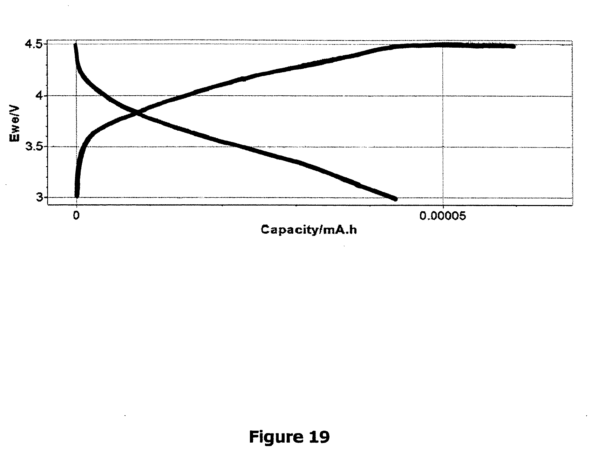

The fabrication of a battery incorporating a modified cathode electrolyte interface is exemplified as follows. In this example a solid state battery comprising of a lithium manganese nickel oxide cathode (356 nm, 30.8 at. % Li, 48.8 at. % Mn and 20.4 at. % Ni), a lithium niobium tantalate buffer layer (15 nm, 57.7 at. % Li, 24.8 at. % Nb and 17.5 at. % Ta) a lithium borosilicate solid electrolyte (813 nm, 79.8 at. % Li, 9.3 at. % B and 10.7 at. % Si), a tin oxide anode (16 nm) and a nickel anode current collector (100 nm) was deposited onto a platinum cathode current collector (a Sapphire//TiO₂/Pt substrate). In this example the solid electrolyte and cathode materials were deposited according to the methods disclosed in GB1400274.5 filed 8th January 2014 and GB1400277.8 filed 8th January 2014 respectively. The buffer layer was deposited according to the methods disclosed herein. The area of the battery was 1.3 mm x 1.3 mm based on the areas of the tin oxide anode and nickel current collectors. Upon completion of the battery fabrication process the sample was transferred to a glove box attached to the deposition system. The battery was charged and discharged a number of times using a Biologic VMP3 instrument. A representative charge-discharge curve measured at a rate of ca. C/2 is shown in Figure 19.

## Claims

1. Mixed oxide of lithium, niobium and tantalum of formula (I):
LiₓNb_{y}Ta_{z}Oₐ (I)
wherein the mixed oxide is a ternary Li-Nb-Ta oxide in which:
- 0.53 ≤ x ≤ 0.56
- 0.15 ≤ y ≤ 0.30, and
- 0.17 ≤ z ≤ 0.29,
wherein x + y + z = 1.00, and
a is ≤ 3.00.

2. Mixed oxide of lithium, niobium and tantalum according to claim 1, wherein said mixed oxide shows:
- an ionic conductivity of at least 2.0 x 10⁻⁶ S/cm, and
- a permittivity calculated at 254 kHz of at least 100.

3. Mixed oxide according to claim 2, wherein said mixed oxide shows an ionic conductivity of at least 3.5 x 10⁻⁶ S/cm.

4. Mixed oxide according to claim 2 or 3, wherein said mixed oxide shows a permittivity calculated at 254 kHz of at least 150.

5. Mixed oxide of lithium, niobium and tantalum according to any one of claims 1 to 4, wherein said mixed oxide is partially amorphous.

6. Process for preparing a mixed oxide of lithium, niobium and tantalum according to any one of claims 1 to 5, wherein the process comprises the following steps:
- a thin film of Li, Nb and Ta oxide is prepared;
- an annealing process is carried out at a temperature of at least 300°C.

7. Process according to claim 6, wherein the film has a thickness of at least 5 nm and at most 1000 nm, more preferably at least 10 nm and at most 500 nm.

8. Process according to claim 6 or 7, wherein the thin film is prepared by a sol-gel process, by physical vapour deposition or by chemical vapour deposition.

9. Process according to any of claims 6 to 8, wherein the annealing process is carried out in an argon atmosphere.

10. An all-solid-state lithium battery comprising the following elements:
- a positive electrode active material layer;
- a buffer layer;
- a solid electrolyte;
- a negative electrode active material layer,
wherein the buffer layer, acting as an interface between the positive electrode active material and the solid electrolyte, contains a mixed oxide of lithium, niobium and tantalum as defined in any of claims 1 to 5.

11. An all-solid-state lithium battery according to claim 10, wherein the buffer layer has a thickness of at least 1 nanometre and at most 1 micrometre.

12. An all-solid-state lithium battery according to claim 10 or 11, wherein the buffer layer comprises particles of the said mixed oxide of lithium, niobium and tantalum, with a mean particle size of at most 0.5 micrometres.

13. An all-solid-state lithium battery comprising the following elements:
- a positive electrode active material layer;
- a solid electrolyte;
- a negative electrode active material layer,
wherein the solid electrolyte contains a mixed oxide of lithium, niobium and tantalum as defined in any of claims 1 to 5.

14. An all-solid-state lithium battery according to claim 13, wherein the solid electrolyte comprises particles of the said mixed oxide of lithium, niobium and tantalum, with a mean particle size of at most 10 micrometres.

15. Use of a mixed oxide of lithium, niobium and tantalum as defined in any of claims 1 to 5 as a buffer layer between a positive electrode active material and a solid electrolyte, in a battery.

16. Use of a mixed oxide of lithium, niobium and tantalum as defined in any of claims 1 to 5 as a solid electrolyte material in a battery.

## Patentansprüche

1. Mischoxid von Lithium, Niob und Tantal der Formel (I):
LiₓNb_{y}Ta_{z}Oₐ (I)
wobei das Mischoxid ein ternäres Li-Nb-Ta-Oxid ist, in welchem 0,53 ≤ x ≤ 0,56,
- 0,15 ≤ y ≤ 0,30 und
- 0,17 ≤ z ≤ 0,29,
wobei x + y + z = 1,00 und
a ≤ 3,00 gilt.

2. Mischoxid von Lithium, Niob und Tantal nach Anspruch 1, wobei das Mischoxid:
- eine ionische Leitfähigkeit von mindestens 2,0 x 10⁻⁶ S/cm und
- eine Permittivität, bei 254 kHz berechnet, von mindestens 100 aufweist.

3. Mischoxid nach Anspruch 2, wobei das Mischoxid eine ionische Leitfähigkeit von mindestens 3,5 x 10⁻⁶ S/cm aufweist.

4. Mischoxid nach Anspruch 2 oder 3, wobei das Mischoxid eine Permittivität, bei 254 kHz berechnet, von mindestens 150 aufweist.

5. Mischoxid von Lithium, Niob und Tantal nach einem der Ansprüche 1 bis 4, wobei das Mischoxid teilweise amorph ist.

6. Verfahren zum Herstellen eines Mischoxids von Lithium, Niob und Tantal nach einem der Ansprüche 1 bis 5, wobei das Verfahren die folgenden Schritte umfasst:
- eine Dünnschicht von Li-, Nb- und Ta-Oxid wird hergestellt,
- ein Glühvorgang wird bei einer Temperatur von mindestens 300 °C ausgeführt.

7. Verfahren nach Anspruch 6, wobei die Schicht eine Dicke von mindestens 5 nm und höchstens 1000 nm, noch bevorzugter mindestens 10 nm und höchstens 500 nm aufweist.

8. Verfahren nach Anspruch 6 oder 7, wobei die Dünnschicht durch ein Sol-Gel-Verfahren, durch physikalische Gasphasenabscheidung oder durch chemische Gasphasenabscheidung hergestellt wird.

9. Verfahren nach einem der Ansprüche 6 bis 8, wobei der Glühvorgang in einer Argonatmosphäre ausgeführt wird.

10. Ganzfestkörper-Lithiumbatterie, umfassend die folgenden Elemente:
- eine Positivelektroden-Aktivmaterialschicht,
- eine Pufferschicht,
- einen festen Elektrolyt,
- eine Negativelektroden-Aktivmaterialschicht,
wobei die Pufferschicht, die als Zwischenstück zwischen dem Positivelektroden-Aktivmaterial und dem festen Elektrolyt wirkt, ein Mischoxid von Lithium, Niob und Tantal, wie in einem der Ansprüche 1 bis 5 definiert, enthält.

11. Ganzfestkörper-Lithiumbatterie nach Anspruch 10, wobei die Pufferschicht eine Dicke von mindestens 1 Nanometer und höchstens 1 Mikrometer aufweist.

12. Ganzfestkörper-Lithiumbatterie nach Anspruch 10 oder 11, wobei die Pufferschicht Teilchen des Mischoxids von Lithium, Niob und Tantal mit einer mittleren Teilchengröße von höchstens 0,5 Mikrometern umfasst.

13. Ganzfestkörper-Lithiumbatterie, umfassend die folgenden Elemente:
- eine Positivelektroden-Aktivmaterialschicht,
- einen festen Elektrolyt,
- eine Negativelektroden-Aktivmaterialschicht,
wobei der feste Elektrolyt ein Mischoxid von Lithium, Niob und Tantal, wie in einem der Ansprüche 1 bis 5 definiert, enthält.

14. Ganzfestkörper-Lithiumbatterie nach Anspruch 13, wobei der feste Elektrolyt Teilchen des Mischoxids von Lithium, Niob und Tantal mit einer mittleren Teilchengröße von höchstens 10 Mikrometern umfasst.

15. Verwendung eines Mischoxids von Lithium, Niob und Tantal, wie in einem der Ansprüche 1 bis 5 definiert, als Pufferschicht zwischen einem Positivelektroden-Aktivmaterial und einem festen Elektrolyt, in einer Batterie.

16. Verwendung eines Mischoxids von Lithium, Niob und Tantal, wie in einem der Ansprüche 1 bis 5 definiert, als festes Elektrolytmaterial in einer Batterie.

## Revendications

1. Oxyde mixte de lithium, niobium et tantale de formule (I) :
LiₓNb_{y}Ta_{z}Oₐ (I)
dans lequel l'oxyde mixte est un oxyde ternaire de Li-Nb-Ta dans lequel :
- 0,53 ≤ x ≤ 0,56
- 0,15 ≤ y ≤ 0,30, et
- 0,17 ≤ z ≤ 0,29,
dans lequel x + y + z = 1,00, et
a est ≤ 3,00.

2. Oxyde mixte de lithium, niobium et tantale selon la revendication 1, dans lequel ledit oxyde mixte présente :
- une conductivité ionique d'au moins 2,0 x 10⁻⁶ S/cm, et
- une permittivité calculée à 254 kHz d'au moins 100.

3. Oxyde mixte selon la revendication 2, dans lequel ledit oxyde mixte présente une conductivité ionique d'au moins 3,5 x 10⁻⁶ S/cm.

4. Oxyde mixte selon la revendication 2 ou 3, dans lequel ledit oxyde mixte présente une permittivité calculée à 254 kHz d'au moins 150.

5. Oxyde mixte de lithium, niobium et tantale selon l'une quelconque des revendications 1 à 4, dans lequel ledit oxyde mixte est partiellement amorphe.

6. Procédé de préparation d'un oxyde mixte de lithium, niobium et tantale selon l'une quelconque des revendications 1 à 5, dans lequel le procédé comprend les étapes suivantes :
- un mince film d'oxyde de Li, Nb et Ta est préparé ;
- un procédé de recuit est réalisé à une température d'au moins 300°C.

7. Procédé selon la revendication 6, dans lequel le film présente une épaisseur d'au moins 5 nm et d'au plus 1 000 nm, encore mieux d'au moins 10 nm et d'au plus 500 nm.

8. Procédé selon la revendication 6 ou 7, dans lequel le mince film est préparé par un procédé sol-gel, par dépôt physique en phase vapeur ou par dépôt chimique en phase vapeur.

9. Procédé selon l'une quelconque des revendications 6 à 8, dans lequel le procédé de recuit est réalisé dans une atmosphère d'argon.

10. Accumulateur au lithium à l'état entièrement solide comprenant les éléments suivants :
- une couche de matière active d'électrode positive ;
- une couche tampon ;
- un électrolyte solide ;
- une couche de matière active d'électrode négative,
dans lequel la couche tampon, agissant comme une interface entre la matière active d'électrode positive et l'électrolyte solide, contient un oxyde mixte de lithium, niobium et tantale comme défini dans l'une quelconque des revendications 1 à 5.

11. Accumulateur au lithium à l'état entièrement solide selon la revendication 10, dans lequel la couche tampon présente une épaisseur d'au moins 1 nanomètre et d'au plus 1 micromètre.

12. Accumulateur au lithium à l'état entièrement solide selon la revendication 10 ou 11, dans lequel la couche tampon comprend des particules dudit oxyde mixte de lithium, niobium et tantale, avec une taille moyenne de particule d'au plus 0,5 micromètre.

13. Accumulateur au lithium à l'état entièrement solide comprenant les éléments suivants :
- une couche de matière active d'électrode positive ;
- un électrolyte solide ;
- une couche de matière active d'électrode négative,
dans lequel l'électrolyte solide contient un oxyde mixte de lithium, niobium et tantale comme défini dans l'une quelconque des revendications 1 à 5.

14. Accumulateur au lithium à l'état entièrement solide selon la revendication 13, dans lequel l'électrolyte solide comprend des particules dudit oxyde mixte de lithium, niobium et tantale, avec une taille moyenne de particule d'au plus 10 micromètres.

15. Utilisation d'un oxyde mixte de lithium, niobium et tantale comme défini dans l'une quelconque des revendications 1 à 5 comme une couche tampon entre une matière active d'électrode positive et un électrolyte solide, dans un accumulateur.

16. Utilisation d'un oxyde mixte de lithium, niobium et tantale comme défini dans l'une quelconque des revendications 1 à 5 comme une matière d'électrolyte solide dans un accumulateur.
